# EUROPEAN PATENT SPECIFICATION

(11) **EP 2 471 351 B1**
(45) Date of publication and mention of the grant of the patent: **04.05.2016**
(21) Application number: 10840530.9
(22) Date of filing: 23.12.2010
(51) Int. Cl.: H05K 1/18, H01L 23/66, H01L 23/36

(54) **A MICROWAVE UNIT AND METHOD THEREFORE**
MIKROWELLENEINHEIT UND VERFAHREN DAFÜR
UNITÉ À MICRO-ONDES ET PROCÉDÉ POUR CELLE-CI

(30) Priority: 31.12.2009 WO PCT/SE2009/000545
(43) Date of publication of application: 04.07.2012
(73) Proprietor: Huawei Technologies Co., Ltd., Longgang District Shenzhen, Guangdong 518129 (CN)
(72) Inventor: BERGSTEDT, Leif, S-432 52 Varberg (SE); MADEBERG, Bengt, S-164 40 Kista (SE)
(74) Representative: Thun, Clemens
(86) International application number: PCT/CN2010/080155
(87) International publication number: WO 2011/079741

(56) References cited:
- EP-A2- 0 915 515
- CN-A- 101 088 162
- JP-A- H07 122 902
- US-A- 4 649 418
- US-A- 5 856 911
- US-A- 6 011 692
- US-A1- 2003 030 516
- US-A1- 2004 080 386
- US-A1- 2004 212 081
- US-B1- 6 437 669

## Description

### FIELD OF THE INVENTION

The present invention relates to a microwave unit comprising a motherboard and a package adapted to be assembled automatically in a Surface Mounted Device, SMD, machine.

### BACKGROUND OF THE INVENTION

There is a goal in the commercial microwave industry to fully automatize mass volume manufacturing of microwave units. To solve this problem, MMICs (Monolithic Microwave Integrated Circuits) have been packaged in packages that are possible to attach and solder in a fully automatic Surface Mounted Device machine (Pick and Place machine). A main problem with these packages is that it is difficult to have a controlled matched signal and ground way in to the package and out of the package.

The article "A 1-Watt Ku-band Power Amplifier MMIC using Cost-effective Organic SMD Package", 34th European Microwave Conference - Amsterdam, 2004, by A. Bessemoulin, M. Parisot, P. Quentin, C. Saboureau, M. van Heijningen, J. Priday, relates to a microwave organic SMD power package. The MMIC is attached onto a thickened copper slug (120 µm), within a cavity made in low-cost 8-mils RO4003 substrate. The electrical interconnections are realized with gold bond wires connecting the MMIC pads to feed lines on the package front side, themselves connected to the package leads, through the package substrate by means of RF vias. After covering with a lid, the device can be mounted, by a reflow soldering technique for instance. The general principle with this solution is to "keep it small".

U.S. Patent No. US6011692 relates to an element for supporting one or more chips to facilitate the mounting thereof on circuit boards. The chip supporting element comprises a ductile foil of electrically and thermally conducting material, and a stabilizing frame of dielectric material fixed to the foil around the site where at least one chip is to be located in contact with the foil. For low-power inventions, the chip supporting element would constitute a complete chip module to be mounted on a circuit board.

US 2003 030 516 A1 provides a connected construction of a high-frequency package and a wiring board having an excellent high-frequency transmission characteristic, without degradation of the transmission characteristic of even high-frequency signals in a wide band ranging from 20 GHz to 80 GHz.

EP 0 915 515 A2 discloses an arrangement includes signal lines for a thermally isolated module (M1) which is cooled or heated from the lower surface of a base plate. At least an adjacent module (M2, M3) is provided on the lower surface of the base plate and has an electrically conducting bearing. An electrical field is formed between the signal lines.

US 2004 080 368 A1 shows a reinforcing substrate 60 which fixes and holds the line lead frame and the GND frames. The reinforcing substrate 60 is made of FR-4 printed wiring board.

### SUMMARY OF THE INVENTION

Problems in prior art are solved in a first aspect by a method of interconnecting a microwave package and a mother-board in a Surface Mounted Device, SMD, wherein the motherboard is arranged for carrying electrical circuitry other than said microwave package, wherein a signal path or layer of said motherboard and said microwave package, respectively, are aligned in a single plane; and characterized in that the signal path or layer of said motherboard and said package, respectively, are interconnected by a connecting component comprising a substrate wing means having a top surface and a opposed bottom surface and four side surfaces confining the extension of the top and bottom surfaces and being provided between the top surface and the bottom surfaces and the top surface is a surface facing away from an air gap between the motherboard and said microwave package, wherein a connecting strip is provided on the bottom surface of the wing means, the two ends of said connecting strip forming two solder pads being strips are provided both on the bottom surface of the substrate and which are configured to connect the connecting element to the mother board and said microwave package, wherein furthermore a solder mask being a strip is provided onto the bottom surface of the substrate wing means and on the connecting strip between the two solder pads, wherein a main extension direction of the solder mask is perpendicular to a main extension direction of the bottom surface of the substrate connecting strip, wherein the solder mask is provided over the air gap.

An advantage with the microwave unit is that the signal level will have an unbroken continuity in to and out from the package. A further advantage according to an aspect of the invention is that it is possible to assemble microwave units automatically.

Further, due to the ground pads a alignment of the package to the motherboard is possible and furthermore the ground level can be made on the same level at both the motherboard and at the package. Hereby, a good mechanical structure is secured. Furthermore, it is also easier to implement copper sheets in the package.

Further, the wing means are operable to adjust the air gap in the connection area. Furthermore, the connecting component with the solder mask is operable to adjust the mean value of the dielectric constant at the air gap area. Hereby is achieved a good function of the signal connection between the component and the motherboard.

Furthermore, it is an advantage that the solder mask also is operable to control the soldering points.

A further advantage in this context is achieved if the connecting component is a printed circuit board, PCB, made of laminate.

Furthermore, in a second aspect a microwave unit is provided comprising a motherboard and a microwave package, the microwave unit being adapted to be assembled automatically in an SMD machine, comprising a connecting component interconnecting the signal path or layer of said motherboard and said microwave package, characterized in that the connecting component comprises a wing means having a top surface and a opposed bottom surface and four side surfaces confining the extension of the top surface and bottom surfaces and being provided between the top and bottom surfaces and the top surface is a surface facing away from an air gap between the motherboard and said microwave package, wherein a connecting strip is provided on the bottom surface of the wing means, the two ends of said connecting strip forming two solder pads which connect the connecting element to the mother board and said microwave package, wherein furthermore a solder mask being a strip is provided on the bottom surface of the wing means and on the connecting strip between the two solder pads, wherein a main extension direction of the solder mask is perpendicular to a main extension direction of the connecting strip, wherein the solder mask is provided over the air gap.

It will be noted that the term "comprises/comprising" as used in this description is intended to denote the presence of a given characteristic, step or component, without excluding the presence of one or more other characteristic, features, integers, steps, components or groups thereof.

Embodiments of the invention will now be described with a reference to the accompanying drawings, in which:

### BRIEF DESCRIPTION OF THE DRAWINGS

Fig. 1 is a cross-sectional view of a microwave unit according to the present invention;
Fig. 2 is a side view of a first embodiment of a connecting component comprised in the microwave unit according to the present invention;
Figs. 3A and 3B are a side view and a top view, respectively, of an example not forming part of the invention of a connecting component comprised in the microwave unit;
Fig. 4 is a cross-sectional view of an example not forming part of the invention of an air gap included in the microwave unit;
Fig. 5 is a cross-sectional view of an example not forming part of the invention of an air gap included in the microwave unit;
Figs. 6A and 6B are a top view and a side view, respectively, illustrating a micro-strip adapted soldering tag comprised in the microwave unit according to an example not forming part of the present invention; and
Fig. 7 is a cross-sectional view illustrating the lower level of soldering surfaces comprised in the microwave unit according to an example not forming part of the present invention.

### DETAILED DESCRIPTION OF THE EMBODIMENTS

A major disadvantage with the SMD package solution of 2004, referred to in the background section, is to provide heat transport from the package. A very good cooling must be attached directly under the centre of the package. A further disadvantage is that this package has frequency limitations because of the "zig-zag" way of the signal from the under side of the package. The problem is that as the ground and signal plane is not at the same level as the micro-strip structure at the motherboard there are limitations concerning upper frequency and signal losses. Typically there is a practically upper limit of some 40 GHz. Regarding the heat sink problem for Power Amplifier packages, this result in special printed circuit boards with in-laminated copper sheets; so called "coins" to spread out the heat from the package.

U.S. Patent No. US6011692 as briefly described in the background section, e.g., does not disclose or suggest how to solve automatic manufacturing and how to handle mismatch of micro-strip conductor width between the module/package and the motherboard. For high-power inventions, the chip supporting element would have to be fixed to a heat sink on a circuit board, such as a mother board.

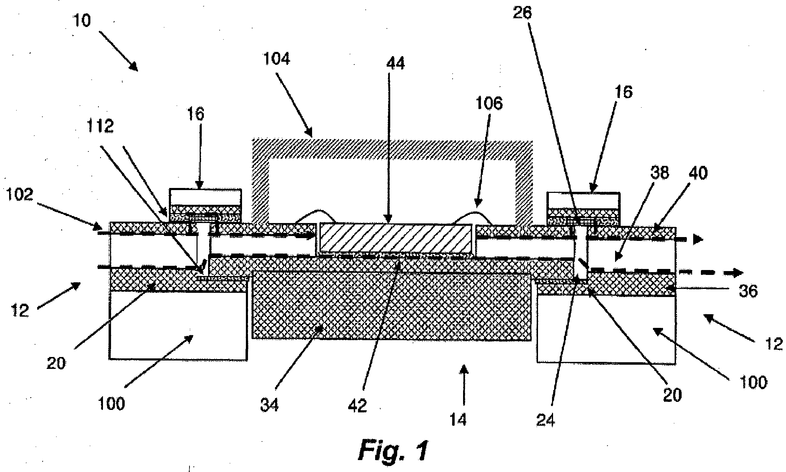

In Fig. 1 there is disclosed a cross-sectional view of a microwave unit 10 according the present invention. The microwave unit 10 comprises a motherboard 12 and a package 14. The microwave unit 10 is adapted to be assembled automatically in a Surface Mounted Device, SMD, machine (not included in the figure). As also is apparent in Fig. 1, the microwave unit 10 comprises, in this case two, connecting components 16, each connected between the motherboard 12 and the package 14. The connecting component 16 is operable to make the signal ways 102 on the same level at both the motherboard 12 and at the package 14. Furthermore, the microwave unit 10 also comprises ground pads 20, operable to align the package 14 to the motherboard 12. The ground pads 20 are also operable to make the ground level on the same level at both the motherboard 12 and at the package 14. As also is apparent in Fig. 1, there is an air gap 24 between the motherboard 12 and the package 14, and the connecting component 16 is arranged over the air gap 24.

The motherboard 12 comprises a number of layers, namely a multilayer PCB 100 of glass epoxy that also is the mechanical carrier, a ground layer 36, a dielectric layer 38, and an upper layer 40. The upper layer 40 comprises copper foil coated with e. g. Ni/Au, or Ni/Pd/Au, or Ag/Au. The ground layer 36 is thicker than the upper layer 40.

As also is apparent in Fig. 1, the package 14 comprises a layer 42 of silver epoxy that attach a Monolithic Microwave Integrated Circuit, MMIC, 44. Beneath the layer 42 is a heat sink means 34, made of e. g. copper or brass, coated with e. g. Ni/Au.

Also indicated in Fig. 1 are solder 112, a cap 104 arranged over the MMIC 44, and bond wires 106 connecting the MMIC 44 to the package 14.

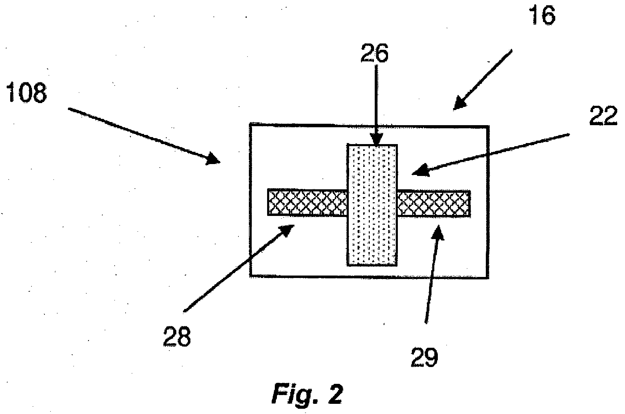

In Fig. 2 there is disclosed a side view of the connecting component 16. The side that is disclosed in Fig. 2 is the side of the connecting component 16 facing on to the motherboard 12, the air gap 24, and the package 14. (See Fig. 1). The connecting component 16 comprises a wing means 22 arranged over the air gap 24 (see Fig. 1) between the motherboard 12 and the package 14. The wing means 22 is operable to adjust the air gap 24 in the connection area. Furthermore, the connecting component 16 comprises a solder mask 26, covering the wing means 22 and operable to adjust the mean value of the dielectric constant at the air gap area. As also is apparent in Fig. 2, the connecting component 16 also comprises soldering pads 28, 29 operable to connect the connecting component 16 to the motherboard 12 and to the package 14. Furthermore, the solder mask 26 is also operable to control the soldering points. Also disclosed in Fig. 2 is the laminate 108. This connecting component 16 is a vital part to get good function of the signal connection (see Fig. 1, 102) between the MMIC 44 and the motherboard 12.

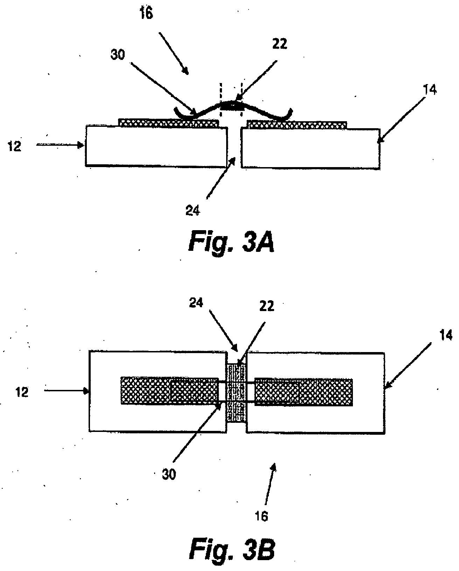

In Figs. 3A and 3B there are disclosed a side view and a top view, respectively, of an example not forming part of the invention of a connecting component 16. In this particular example, the connecting component 16 comprises ribbon-bonding 30 operable to connect the motherboard 12 and the package 14. Furthermore, the connecting component 16 also comprises a wing means 22 arranged over the air gap 24 between the motherboard 12 and the package 14. As in the invention, the wing means 22 is operable to adjust the air gap 24 in the connection area. In FIG. 3A there is schematically disclosed, between the broken lines, the so called wing part of the ribbon-bonding 30.

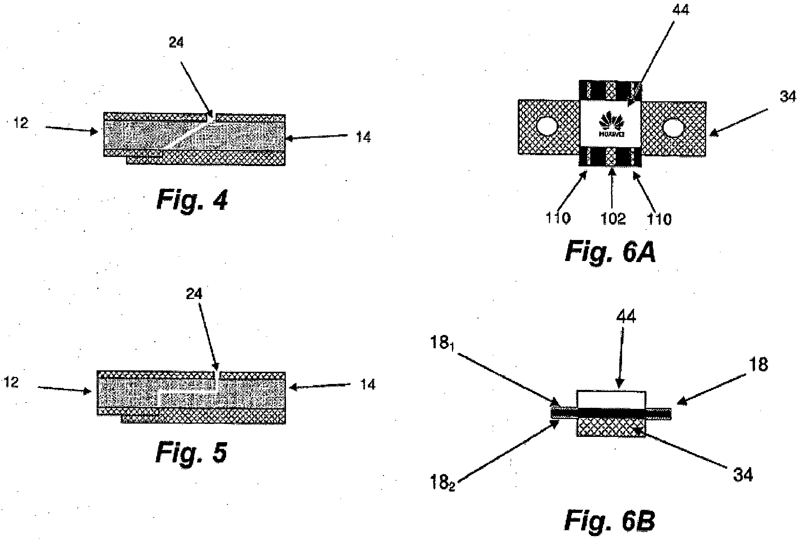

The air gap 24 between the motherboard 12 and the package 14 should normally be very short and have a low influence on the signal properties. However, with higher frequencies this could be more critical. The reason for the problems is that the conductor dimensions at the air gap 24 will be more adapted to the conditions at the motherboard 12 and the package 14 as the dielectric is set by the laminates. Here the dielectric constants are some 2.3 to 3.5. In the air gap 24 there is only air with a dielectric constant Dk of 1. A way to handle this is to design the air gap 24 in a special way, as in Figs. 4, and 5.

In Fig. 4 there is disclosed a cross-sectional view of an example not forming part of the invention of the air gap 24. In this example, the air gap 24 has an inclining cross section. It is pointed out that it is the same or corresponding cross-section that is disclosed in both Fig. 1 and Fig. 4, while illustrated as a step in Fig. 1.

In Fig. 5 there is disclosed a cross-sectional view of a further example not forming part of the invention of the air gap 24. In this particular example the air gap 24 has a stepped cross section. It is pointed out that it is the same or corresponding cross-section that is disclosed in both Fig. 1 and Fig. 5.

With the air gap 24 designed either as disclosed in Fig. 4 or in Fig. 5, and if we assume the worst case of 50% air and 50% laminate, wherein the laminate has a dielectric constant Dk of 3.5, the result will be Dk = (1 + 3.5)/2 = 2.25. This implies a less difference between the dielectric constants than in the case disclosed in Fig. 1.

In Figs. 6A and 6B there are disclosed a top view and a side view, respectively, illustrating a micro-strip adapted soldering tag 18 comprised in the microwave unit 10 according examples not forming part of the present invention. As is apparent in Fig. 6B, the soldering tag 18 is soldered at both sides 181 and 182. Also disclosed is the MMIC 44, and the heat sink means 34, here in the form of copper flanges. Also disclosed in Fig. 6A are the signal way 102, and the bias ways 110.

The version disclosed in Figs. 6A and 6B is a proposed version for microwave radios. However, depending of radio-invention the versions can be of several types. For radio links it is often good to move the heat in direction "up" because there is always an Al-shielding of the microwave unit. Furthermore, the diplexer is also often attached to this shielding.

A version, not disclosed in a figure, for Base-radio PA will probably have a bigger metal carrier and be designed to have the heat transport downwards.

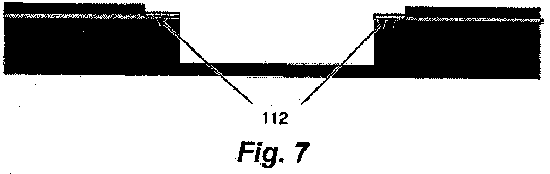

In Fig. 7 there is disclosed a cross-sectional view illustrating the lower level of soldering surfaces comprised in the microwave unit 10 according an example not forming part of the present invention. In Fig. 7 there is disclosed the soldering paste 112, which must be disposed by automatic pipe or manual, when assembling at an SMD-line.

The motherboard 12 is normally implemented by normal PCB manufacturing, except the clearance of the ground under the microwave laminate. However, this can be produced in two different ways:
- By laser-cut if the laminate permit this.
- By contact milling. However, then we need a 70 µm copper foil under the microwave laminate. Normally the ground layer 36 under the microwave dielectric 38 is just 18 µm because microwave laminate mostly are sold with 18 µm copper at both sides. IN our case we will need 18 µm at one side and 70 µm at the other side. But the thicker 70 µm Cu will improve the heat distribution at the microwave board and gain the MTBF.

The idea with the package 14 is to base the design with the new version of TAC-LAM-plus. However, other laminates are possible. A typical built up of the laminate can be 18 µm Cu + 100 µm PTFE + 1-2 mm Cu. The general idea is to have the laminate "chip-thick" so when the pocket for the chips is laser milled and the chip attached, the chip surface shall be at the same level as the dielectric at the package 14. The carrier - mostly copper - is pre-milled before manufacturing. The process of producing the package 14 will probably include one lamination step, a couple of laser drilling/milling steps, and probably two copper plating steps.

The total effects of the thus embodied invention can be summarized as follows:
- Possible to have automatic assembled packages 14 up to at least 80 GHz.
- Better performances than for existing packages even at some 2 GHz.
- Simpler microwave boards than today because most of the heat sink infrastructure will be at the package 14.
- Possible to assemble MMICs in packages 14 for one chip/MMIC. This implies that it is possible to assemble the microwave units 10 with the aid of a Pick-and-Place machine. If a chip is being breaked, when using a package 14 for one chip, then it is possible to solder away the broken component, and to solder a new one in place. It is also possible to test the chip in the package 14.

The invention is not limited to the described embodiments. It will be evident for those skilled in the art that many different modifications are feasible within the scope of the following Claims.

## Claims

1. A method of interconnecting a microwave package (14) and a mother-board(12) in a Surface Mounted Device, SMD, wherein the motherboard is arranged for carrying electrical circuitry other than said microwave package (14), wherein a signal path or layer (102) of said motherboard (12) and said microwave package (14), respectively, are aligned in a single plane; and
**characterized in that**
the signal path or layer of said motherboard and said package, respectively, are interconnected by a connecting component (16) comprising a wing means (22) having a top surface and a opposed bottom surface and four side surfaces confining the extension of the top and bottom surfaces and being provided between the top surface and the bottom surface and the top surface is a surface facing away from an air gap between the motherboard (12) and said microwave package (14), wherein a connecting strip is provided on the bottom surface of the wing means, the two ends of said connecting strip forming two solder pads (28, 29) which are configured to connect the connecting element (16) to the mother board (12) and said microwave package (14), wherein furthermore a solder mask (26) being a strip is provided onto the bottom surface of the wing means (22) and on the connecting strip between the two solder pads (28, 29), wherein a main extension direction of the solder mask (26) is perpendicular to a main extension direction of the connecting strip, wherein the solder mask (26) is provided over the air gap (24).

2. The method according to claim 1, wherein the signal path or layer of said motherboard and said package, respectively, are aligned with a signal path or layer of an Monolithic Microwave Integrated Circuit, MMIC, or a microwave power amplifier (44) included in the microwave package.

3. The method according to claim 1, wherein a profile of a hole in the motherboard is shape adapted to a profile of the microwave package.

4. The method according to claim 3, wherein the microwave package includes a heat sink (34) and wherein the heat sink is attached to a ground layer of the microwave package.

5. The method according to claim 4, wherein the heat sink and the hole of the motherboard provide a heat transport through the heat sink and the hole of the motherboard, and wherein said heat transport is greater than transport in the motherboard of heat from the microwave package during operations.

6. A microwave unit (10) comprising a motherboard (12) and a microwave package (14), the microwave unit (10) being adapted to be assembled automatically in an SMD machine,
comprising a connecting component (16) interconnecting the signal path or layer of said motherboard and said microwave package, **characterized in that** the connecting component (16) comprises a wing means (22) having a top surface and a opposed bottom surface and four side surfaces confining the extension of the top surface and bottom surface and being provided between the top and bottom surfaces and the top surface is a surface facing away from an air gap between the motherboard (12) and said microwave package (14), wherein a connecting strip is provided on the bottom surface of the wing means, the two ends of said connecting strip forming two solder pads (28, 29) which connect the connecting element (16) to the mother board (12) and said microwave package (14), wherein furthermore a solder mask (26) being a strip is provided on the bottom surface of the wing means (22) and on the connecting strip between the two solder pads (28, 29), wherein a main extension direction of the solder mask (26) is perpendicular to a main extension direction of the connecting strip, wherein the solder mask (26) is provided over the air gap (24).

7. A microwave unit (10) according to claim 6, wherein said air gap (24) has an inclining cross section.

8. A microwave unit (10) according to claim 6, wherein said motherboard (12) comprises a ground layer (36), a dielectric layer (38) upon said ground layer (36), and an upper layer (40) upon said dielectric layer (38), wherein said ground layer (36) is thicker than said upper layer (40).

9. A microwave unit (10) according to claim 6, wherein said package (14) comprises a layer (42) of silver epoxy that attach a Monolithic Microwave Integrated Circuit, MMIC, (44).

## Patentansprüche

1. Verfahren zum Verbinden eines Mikrowellenpakets (14) mit einer Hauptplatine (12) in einem oberflächenmontierten Bauelement (Surface Mounted Device, SMD), wobei die Hauptplatine ausgelegt ist, außer dem Mikrowellenpaket (14) elektrische Schaltungen zu tragen, wobei ein Signalweg oder eine Signalschicht (102) der Hauptplatine (12) bzw. des Mikrowellenpakets (14) auf einer einzigen Ebene ausgerichtet sind; und
**dadurch gekennzeichnet, dass**
der Signalweg oder die Signalschicht der Hauptplatine bzw. des Pakets durch eine Verbindungskomponente (16) miteinander verbunden sind, die ein Flügelmittel (22) mit einer Oberseitenfläche und einer gegenüberliegenden Unterseitenfläche und vier Seitenflächen umfasst, die die Ausdehnung der Ober- und Unterseitenflächen begrenzen und zwischen der Oberseitenfläche und der Unterseitenfläche bereitgestellt sind, wobei die Oberseitenfläche eine Oberfläche ist, die von einem Luftspalt zwischen der Hauptplatine (12) und dem Mikrowellenpaket (14) weg zeigt, wobei ein Verbindungsstreifen auf der Unterseitenfläche des Flügelmittels bereitgestellt wird und die beiden Enden des Verbindungsstreifens zwei Lötinseln (28, 29) bilden, die dafür ausgelegt sind, das Verbindungselement (16) mit der Hauptplatine (12) und dem Mikrowellenpaket (14) zu verbinden, wobei ferner eine Lötstoppmaske (26) in Form eines Streifens auf der Unterseitenfläche des Flügelmittels (22) und auf dem Verbindungsstreifen zwischen den beiden Lötinseln (28, 29) bereitgestellt wird, wobei eine Haupterstreckungsrichtung der Lötstoppmaske (26) senkrecht zu einer Haupterstreckungsrichtung des Verbindungsstreifens verläuft, wobei die Lötstoppmaske (26) über dem Luftspalt (24) bereitgestellt wird.

2. Verfahren gemäß Anspruch 1, wobei der Signalweg oder die Signalschicht der Hauptplatine bzw. des Pakets an einem Signalweg oder einer Signalschicht einer integrierten monolithischen Mikrowellenschaltung (Monolithic Microwave Integrated Circuit, MMIC) oder eines Mikrowellen-Leistungsverstärkers (44), die/der im Mikrowellenpaket enthalten ist, ausgerichtet sind.

3. Verfahren gemäß Anspruch 1, wobei ein Profil eines Lochs in der Hauptplatine an ein Profil des Mikrowellenpakets formangepasst ist.

4. Verfahren gemäß Anspruch 3, wobei das Mikrowellenpaket eine Wärmesenke (34) aufweist und wobei die Wärmesenke an einer Grundschicht des Mikrowellenpakets angebracht ist.

5. Verfahren gemäß Anspruch 4, wobei die Wärmesenke und das Loch der Hauptplatine für einen Wärmetransport durch die Wärmesenke und das Loch der Hauptplatine sorgen und wobei der Wärmetransport größer als der Transport von Wärme von dem Mikrowellenpaket in der Hauptplatine während des Betriebs ist.

6. Mikrowelleneinheit (10), die eine Hauptplatine (12) und ein Mikrowellenpaket (14) umfasst, wobei die Mikrowelleneinheit (10) dafür ausgelegt ist, automatisch in einen SMD-Automaten eingebaut zu werden,
die eine Verbindungskomponente (16) umfasst, die den Signalweg oder die Signalebene der Hauptplatine bzw. des Mikrowellenpakets miteinander verbindet, **dadurch gekennzeichnet, dass** die Verbindungskomponente (16) ein Flügelmittel (22) mit einer Oberseitenfläche und einer gegenüberliegenden Unterseitenfläche und vier Seitenflächen umfasst, die die Ausdehnung der Oberseitenfläche und der Unterseitenfläche begrenzen und zwischen der Ober- und Unterseitenfläche bereitgestellt sind, wobei die Oberseitenfläche eine Oberfläche ist, die von einem Luftspalt zwischen der Hauptplatine (12) und dem Mikrowellenpaket (14) weg zeigt, wobei ein Verbindungsstreifen auf der Unterseitenfläche des Flügelmittels bereitgestellt wird und die beiden Enden des Verbindungsstreifens zwei Lötinseln (28, 29) bilden, die die Verbindungskomponente (16) mit der Hauptplatine (12) und dem Mikrowellenpaket (14) verbinden, wobei ferner eine Lötstoppmaske (26) in Form eines Streifens auf der Unterseitenfläche des Flügelmittels (22) und auf dem Verbindungsstreifen zwischen den beiden Lötinseln (28, 29) bereitgestellt wird, wobei eine Haupterstreckungsrichtung der Lötstoppmaske (26) senkrecht zu einer Haupterstreckungsrichtung des Verbindungsstreifens verläuft, wobei die Lötstoppmaske (26) über dem Luftspalt (24) bereitgestellt wird.

7. Mikrowelleneinheit (10) gemäß Anspruch 6, wobei der Luftspalt (24) einen ansteigenden Querschnitt aufweist.

8. Mikrowelleneinheit (10) gemäß Anspruch 6, wobei die Hauptplatine (12) eine Grundschicht (36), eine dielektrische Schicht (38) auf der Grundschicht (36) und eine Oberschicht (40) auf der dielektrischen Schicht (38) umfasst, wobei die Grundschicht (36) dicker als die Oberschicht (40) ist.

9. Mikrowelleneinheit (10) gemäß Anspruch 6, wobei das Paket (14) eine Schicht (42) aus Silberepoxid umfasst, auf der eine integrierte monolithische Mikrowellenschaltung, MMIC, (44) befestigt ist.

## Revendications

1. Procédé permettant d'interconnecter un boîtier micro-onde (14) et une carte mère (12) dans un composant pour montage en surface, SMD, la carte mère étant conçue pour porter une circuiterie électrique autre que ledit boîtier micro-onde (14), un chemin ou une couche de signal (102) de ladite carte mère (12) et dudit boîtier micro-onde (14), respectivement, étant alignés dans un seul plan ; et
**caractérisé en ce que**
le chemin ou la couche de signal de ladite carte mère et dudit boîtier, respectivement, sont interconnectés par un composant de connexion (16) comprenant un moyen de support latéral (22) ayant une surface supérieure et une surface inférieure opposée et quatre surfaces latérales confinant l'extension des surfaces supérieure et inférieure et étant fournies entre la surface supérieure et la surface inférieure, et la surface supérieure est une surface orientée à l'opposé d'un entrefer entre la carte mère (12) et ledit boîtier micro-onde (14), une bande de connexion étant fournie sur la surface inférieure du moyen de support latéral, les deux extrémités de ladite bande de connexion formant deux plots de soudure (28, 29) qui sont configurés pour connecter l'élément de connexion (16) à la carte mère (12) et au dit boîtier micro-onde (14), un masque de soudure (26) étant une bande étant en outre fourni sur la surface inférieure du moyen de support latéral (22) et sur la bande de connexion entre les deux plots de soudure (28, 29), une direction d'extension principale du masque de soudure (26) étant perpendiculaire à une direction d'extension principale de la bande de connexion, le masque de soudure (26) étant fourni sur l'entrefer (24).

2. Procédé selon la revendication 1, dans lequel le chemin ou la couche de signal de ladite carte mère et dudit boîtier, respectivement, sont alignés avec un chemin ou une couche de signal d'un circuit intégré monolithique hyperfréquence, MMIC, ou d'un amplificateur de puissance à micro-ondes (44) inclus dans le boîtier micro-onde.

3. Procédé selon la revendication 1, dans lequel un profil d'un trou dans la carte mère est adapté au niveau de la forme à un profil du boîtier micro-onde.

4. Procédé selon la revendication 3, dans lequel le boîtier micro-onde comprend un radiateur (34) et le radiateur étant attaché à une couche de terre du boîtier micro-onde.

5. Procédé selon la revendication 4, dans lequel le radiateur et le trou de la carte mère fournissent un transport de chaleur à travers le radiateur et le trou de la carte mère, et ledit transport de chaleur étant supérieur au transport dans la carte mère de chaleur à partir du boîtier micro-onde en mode de fonctionnement.

6. Unité à micro-ondes (10) comprenant une carte mère (12) et un boîtier micro-onde (14), l'unité à micro-ondes (10) étant conçue pour être assemblée automatiquement dans une machine SMD,
comprenant un composant de connexion (16) interconnectant le chemin ou la couche de signal de ladite carte mère et dudit boîtier micro-onde, **caractérisée en ce que** le composant de connexion (16) comprend un moyen de support latéral (22) ayant une surface supérieure et une surface inférieure opposée et quatre surfaces latérales confinant l'extension de la surface supérieure et de la surface inférieure et étant fournies entre les surfaces supérieure et inférieure, et la surface supérieure est une surface opposée à un entrefer entre la carte mère (12) et ledit boîtier micro-onde (14), une bande de connexion étant fournie sur la surface inférieure du moyen de support latéral, les deux extrémités de ladite bande de connexion formant deux plots de soudure (28, 29) qui connectent l'élément de connexion (16) à la carte mère (12) et au dit boîtier micro-onde (14), un masque de soudure (26) étant une bande étant en outre fourni sur la surface inférieure du moyen de support latéral (22) et sur la bande de connexion entre les deux plots de soudure (28, 29), une direction d'extension principale du masque de soudure (26) étant perpendiculaire à une direction d'extension principale de la bande de connexion, le masque de soudure (26) étant fourni sur l'entrefer (24).

7. Unité à micro-ondes (10) selon la revendication 6, ledit entrefer (24) ayant une section transversale inclinable.

8. Unité à micro-ondes (10) selon la revendication 6, ladite carte mère (12) comprenant une couche de terre (36), une couche diélectrique (38) sur ladite couche de terre (36), et une couche supérieure (40) sur ladite couche diélectrique (38), ladite couche de terre (36) étant plus épaisse que ladite couche supérieure (40).

9. Unité à micro-ondes (10) selon la revendication 6, dans lequel ledit boîtier (14) comprend une couche (42) d'époxy argent qui joint un circuit intégré monolithique hyperfréquence, MMIC, (44).
